# EUROPEAN PATENT SPECIFICATION

(11) **EP 1 150 494 B1**
(45) Date of publication and mention of the grant of the patent: **27.08.2003**
(21) Application number: 01111599.5
(22) Date of filing: 15.06.1999
(51) Int. Cl.: H04N 3/15

(54) **Reducing striped noise in CMOS image sensors**
Reduzierung von streifenförmigen Störungen in CMOS Bildsensoren
Dimunition du bruit segmenté dans des détecteurs d'image CMOS

(30) Priority: 17.06.1998 US 99111
(43) Date of publication of application: 31.10.2001
(62) Divisional of application: 99928672.7
(73) Proprietor: Foveon, Inc., Santa Clara, CA 95051 (US)
(72) Inventor: Merrill, Richard B, California 94062 (US); Lyon, Richard F, California 94022 (US); Mead, Carver A, California 95051-0951 (US); Turner, Richard M., California 94041 (US)
(74) Representative: von Hellfeld, Axel, Dr. Dipl.-Phys.,

(56) References cited:
- EP-A- 0 665 685
- EP-A- 0 725 535
- EP-A- 0 915 518

## Description

### BACKGROUND OF THE INVENTION

### 1. Field of the Invention

The present invention relates to image sensor arrays. More particularly, the present invention relates to CMOS image sensor arrays for still camera applications specifically designed to reduce fixed pattern striped noise.

### 2. The Background Art

Integrated image sensors are known in the art. New advances in image sensor technologies have allowed these sensors to be fabricated from complementary metal-oxide semiconductor (CMOS) technology.

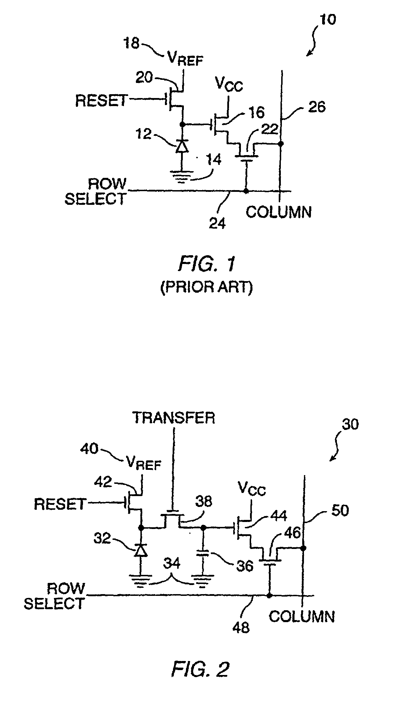

CMOS image sensors and image sensor circuitry may be organized in a manner similar to that which is disclosed in co-pending application serial No. 08/969,383, filed November 13, 1997. Individual pixel sensors may be designed in a number of different ways. One possible pixel sensor design is depicted in FIG. 1. Pixel sensor 10 comprises a photodiode 12 having its anode connected to a fixed voltage potential 14 (shown in FIG. 1 as ground). The cathode of photodiode 12 is connectable to an amplifier 16. The cathode of photodiode 12 is also connectable to a reference potential Vref 18 via a reset switch 20 so that the photodiode 12 is reverse biased. The output of the amplifier 16 is attached to a row-select switch 22, which is connected to a row select line 24 and a column line 26.

The pixel sensor depicted in FIG. 1 is operated as follows. First, the pixel sensor 10 is reset by turning on the reset switch 20. Then the reset switch 20 is turned off so that integration of photocurrent from photodiode 12 can begin. The current from the photodiode 12 is integrated on the amplifier 16 input node capacitance to form a voltage signal. At the appropriate time, the voltage on the row select line is raised, which activates the row-select switches 22 in each pixel sensor 10 in the row. This allows the amplifier 16 to drive column line 26. Column line 26 then leads down to more circuitry that will typically amplify and store the signal, and then convert the signal into digital form for inclusion in a digital pixel stream.

Another possible pixel sensor design is depicted in FIG. 2. This pixel sensor design provides for storage of the signal within the pixel sensor and is thus referred to as a storage pixel sensor 30, while the pixel sensor in FIG. 1 is referred to as a non-storage pixel sensor. Storage pixel sensor 30 comprises a photodiode 32 having its anode connected to a fixed voltage potential 34 (shown in FIG. 2 as ground). The cathode of photodiode 32 is connectable to a storage capacitor 36 via a transfer switch 38. Storage capacitor 36 has a first plate connected to transfer switch 38 and a second plate connected to a fixed potential (shown as ground 34 in FIG. 2). The cathode of photodiode 32 is also connectable to a reference potential Vref 40 via a reset switch 42 so that the photodiode 32 is reverse biased. An amplifier 44 has its input connected to storage capacitor 36. The output of the amplifier 44 is attached to a row-select switch 46, which is connected to a row select line 48 and a column line 50.

The pixel sensor depicted in FIG. 2 is operated as follows. First, the pixel sensor 30 is reset by turning on both reset switch 42 and transfer switch 38. Then the reset switch 42 is turned off so that integration of photocurrent from photodiode 32 can begin. Since transfer switch 38 is turned on, the capacitance of the storage capacitor 36 adds to the capacitance of the photodiode 32 during integration, thereby increasing the charge capacity and therefore intensity range of the storage-pixel sensor. This also reduces variation in the pixel output due to capacitance fluctuations since gate oxide capacitance from which storage capacitor 36 is formed is better controlled than junction capacitance of the photodiode 32.

When the integration is complete (determined by exposure control circuitry, not shown), the transfer switch is turned off, isolating the voltage level corresponding to the integrated photocharge on the storage capacitor 36. Shortly thereafter, the photodiode 32 itself is reset to the reference voltage 40 by again turning on reset switch 42. This action will prevent the photodiode 32 from continuing to integrate during the readout process and possibly overflowing excess charge into the substrate which could affect the integrity of the signal on the storage element.

After the reset switch 42 is turned back on, the readout process can begin. At the appropriate time, voltage on the row select line is raised, which activates the row-select switches 46 in each pixel sensor 30 in the row. This allows the current from the amplifier 44 to travel to column line 50. Column line 50 is coupled to more circuitry that will typically amplify the signal, and then convert the signal into digital form for inclusion in a digital pixel stream.

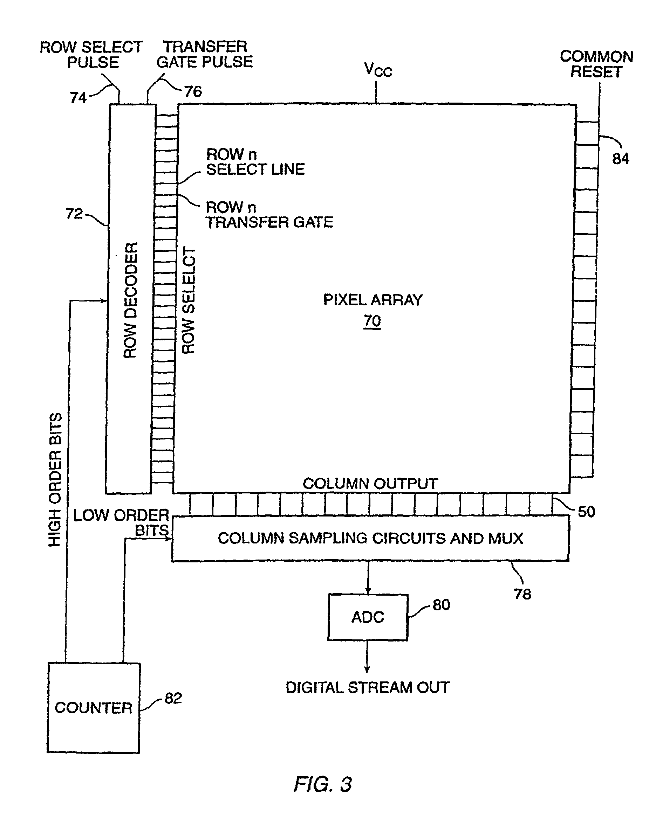

FIG. 3 is a block diagram depicting an example of a pixel sensor array and the surrounding architecture. The pixel sensors are organized in pixel sensor array 70. The row select line of each row of pixel sensors is connected to the row decoder 72. Depending upon the architecture of the pixel sensors, the connection to the row decoder may also be made with a transfer select line. The row decoder 72 receives a row select pulse 74 and activates the row select switches in the appropriate row of pixel sensors. Again, depending upon the architecture of the pixel sensors, the row decoder may or may not receive a transfer gate pulse 76, which activates the transfer switches in the appropriate row of pixel sensors. It is also possible to have an array comprise only a single row of pixel sensors. This is known as a linear imager.

The output of each row of pixel sensors travels down column lines 50 to column sampling and multiplexing circuits 78. This block will amplify each of the column lines and multiplex them, rapidly selecting one at a time, resulting in a stream of amplified signals. This stream will pass through an analog to digital converter 80, such that the output is a stream of digital information. The column sampling circuits and multiplexor block 78 also may store the signals temporarily, for example, to do a subtraction of a noise signal in correlated double sampling architectures. Both the column sampling circuits and multiplexor 78 and the row decoder 72 are controlled by a counter 82.

Additionally, a common reset line 84 is provided which is connected to each pixel sensor's reset switch. Furthermore, in designs using either type of pixel sensor, a correlated double sampling circuit can be added to reduce noise generated by the pixel sensor.

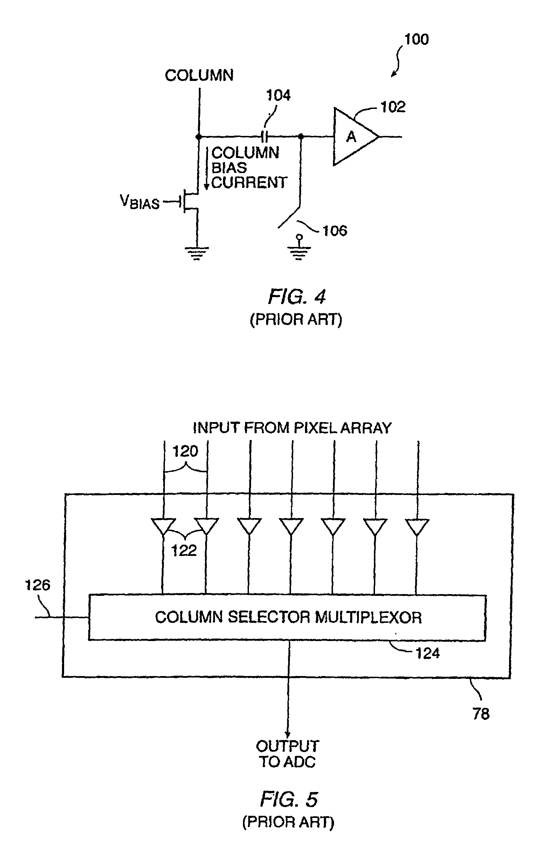

Correlated double sampling can be performed in many different ways, but its function may be generally understood from the following example. FIG. 4 is a circuit diagram depicting an example of a column double sampling circuit 100. One of these circuits may be placed on each column line. The sampling process occurs as follows. First, the signal level for each pixel sensor is read out and stored in the sampling circuitry in the column. Then the transfer switch is turned on again (for that row only) which makes the reference level available to the sampling circuit. This form of double sampling allows for canceling of noise sources in the pixel sensor that are slowly varying compared to the time between the two samples.

With the first signal voltage (V1) present on the left of the capacitor 104, switch 106 is on. The voltage stored across capacitor 104 is equal to the signal voltage V1. Then switch 106 is turned off, and the voltage on the first plate of capacitor 104 moves to a new level (V2) representing the reference voltage. The voltage across capacitor 104 will not change during this time because there is negligible current flowing into the amplifier 102 or through switch 106. Thus both plates of capacitor 104 will change by (V2 - V1), and the voltage at the input of amplifier 102 at the end of the cycle will be (V2 - V1). In this way, noise, offsets, etc can be subtracted from the output of the array. Persons of ordinary skill in the art will recognize that there are other prior art CDS circuits and architectures. A CDS circuit with a CMOS active pixel sensor array was described in Akimoto, et al, United States Patent No. 4,942,474.

FIG. 5 is a block diagram depicting an example of the layout of the column sampling circuits and multiplexor block 78 of FIG. 3. Each column line 120 is coupled to a column amplifier 122, which may include a CDS capability. The column amplifier 122 is then coupled to the multiplexor 124. The multiplexor 124 receives input from an address signal 126, that selects which column should currently be sent to the output. The address signal 126 may be coupled to a counter or other circuit which controls the column address sequence. A signal representative of the voltage on the selected column line 120 is then output, typically to an analog to digital converter.

Fixed pattern noise (FPN) is a visual artifact caused by variation in output pixel values due to device and interconnect mismatches across an image sensor. There are several different kinds of fixed pattern noise, but the most common are random noise and striped noise. Random noise comprises random variations of the individual pixels. Striped noise, on the other hand, comprises random variations from column to column, resulting in vertical bars appearing in the image. The term striped noise really only refers to the stripes occurring in one dimension, since stripes occurring in other dimensions are not usually a problem.

While there are several factors that affect the intensity of fixed pattern noise, the most prominent factor is differences in offsets and gains between amplifiers. Generally, differences in offsets and gains between pixel sensor amplifiers results in random noise, while differences in offsets and gains between column amplifiers results in striped noise. This explains why striped noise is less of a problem in charge-coupled device image sensors (where column amplifiers are not used) than in CMOS image sensors (where column amplifiers generally are used). Random noise can be significantly decreased through the use of correlated double sampling; however, this technique has little or no effect on striped noise.

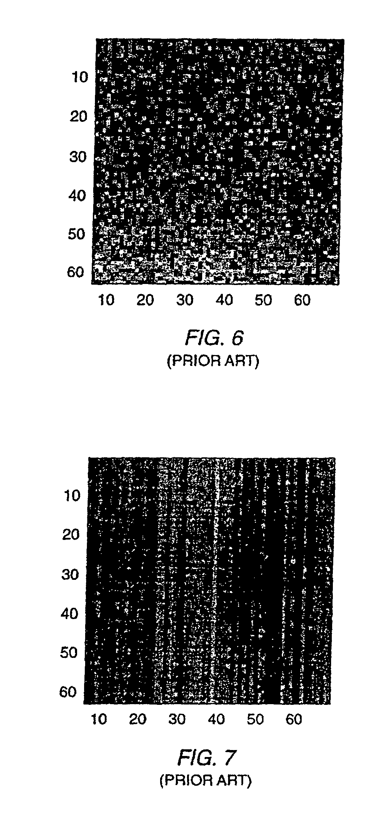

An additional problem arises in CMOS image sensors that use correlated double sampling in that the use of correlated double sampling may be counterproductive. A. El Gamal, B. Fowler, H. Min, and Xinqiao Liu. *Modeling and Estimation of FPN Components in CMOS Image Sensors.* Proceedings of SPIE, January 1998, Vol. 3301, pp. 168-177, discloses that using CDS, while reducing random noise, does not greatly reduce striped noise, thus resulting in an image where almost all of the noise appears as striped noise. FIG. 6 and FIG. 7 are grayscale images depicted in the El Gamal article which show the somewhat detrimental effect of CDS. FIG. 6 is a grayscale image illustrating the fixed pattern noise generated in a system without CDS. The variance of the striped noise is 451,611 while the variance of the random noise is 7,144, 450. This gives a random noise:striped noise variance ratio of 15.8.

FIG. 7 is a grayscale image illustrating the fixed pattern noise generated in a system with CDS. While FIG. 7 contains significantly less random noise, the striped noise is much more noticeable. Random noise is generally less objectionable than striped noise and is useful in masking the intensity of the striped noise. Therefore, the reduction of random noise without a concurrent reduction in striped noise can cause more problems than it solves. The variance of the striped noise is 80,900 and the variance of the random noise is 4,155. This gives a random noise:striped noise variance ratio of 0.05. Thus, the higher the variance ratio the less noticeable the striped noise is. Further investigation has revealed that an architecture in which the fixed pattern noise due to random variations of the pixels is at least 100 times the variance or at least 10 times the root mean square (rms) of the fixed pattern noise due to striped noise is preferred in order to properly mask the striped noise.

A pixel sensor array structure of the at the beginning described type is disclosed in EP-A-665 685.

An object of the present invention is to provide a method that reduces fixed pattern striped noise in CMOS image sensors.

Another object of the present invention is to provide a method that enables fast pixel readout without column amplifiers.

Another object of the present invention is to provide a method that works in such a way that the rms fixed pattern noise due to random variations of the pixels is at least 10 times the rms fixed pattern striped noise.

Another object of the present invention is to provide a method which allows for the dynamic use of a pixel sensor's source follower amplifier transistor to store charge on the column lines and read out column signals by charge sharing alone in order to aid in accomplishing the other objectives.

Another object of the present invention is to provide a method that reduces the effective capacitance of a common output line to speed up settling and lessen blurring of the column signals across a row.

### BRIEF DESCRIPTION OF THE INVENTION

A method according to the invention is set out in claim 1.

### BRIEF DESCRIPTION OF THE DRAWING FIGURES

- FIG. 1: is a circuit diagram depicting an example of a CMOS pixel sensor without storage capability as known in the prior art.
- FIG. 2: is a circuit diagram depicting an example of a CMOS pixel sensor with storage capability as known in the prior art.
- FIG. 3: is a block diagram depicting an example of a image sensor array and the surrounding architecture as known in the prior art.
- FIG. 4: is a circuit diagram depicting an example of a column double sampling circuit as known in the prior art.
- FIG. 5: is a circuit diagram depicting an example of the column sampling circuits and multiplexor block of FIG. 3 as known in the prior art.
- FIG. 6: is a grayscale image illustrating the fixed pattern noise generated in a system without CDS.
- FIG. 7: is a grayscale image illustrating the fixed pattern noise generated in a system with CDS.
- FIG. 8: is a circuit diagram of a pixel sensor array structure.
- FIG. 9: is a signal flow diagram depicting the implicit representation of the chargeshared column readout arrangement as first-order linear discrete-time filter.
- FIG. 10: is a signal flow diagram depicting a two-tap FIR filter for correcting the blurring in the pixel output.
- FIG. 11: is a layout drawing depicting a column select switch having an annular layout.
- FIG. 12A: is a layout diagram of the top view of a multiple level driven shield.
- FIG. 12B: is a layout diagram of a the side view of a multiple level driven shield taken along section line 12B-12B of FIG. 12A.

### DETAILED DESCRIPTION OF A PREFERRED EMBODIMENT

Those of ordinary skill in the art will realize that the following description of the present invention is illustrative only and not in any way limiting. Other embodiments of the invention will readily suggest themselves to such skilled persons.

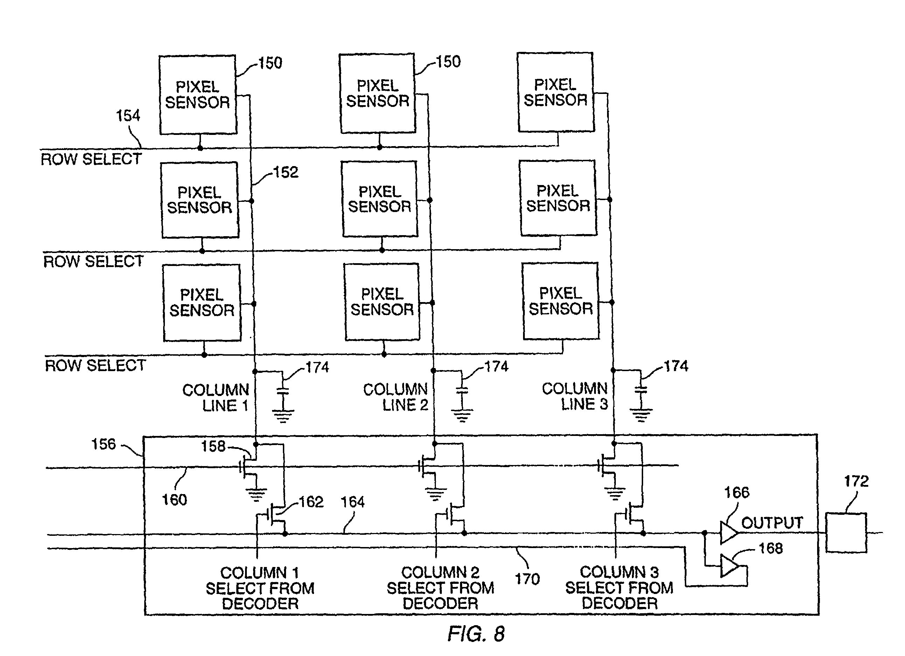

FIG. 8 is a circuit diagram depicting a presently preferred sensor array structure. Pixel sensors 150 are organized in an array as known in the prior art. FIG. 8 depicts an array that has three rows and three columns but the present invention may be used with a pixel sensor array that is of any size. Each pixel sensor may be coupled to a column line 152 and to a row select line 154 as depicted in FIGS. 1-2. The pixel sensors 150 may be of any type and are not limited to the embodiments described in FIG. 1-2. In the multiplexor block 156, the column lines 152 are coupled to load devices 158, which may provide a bias current. The load devices 158 may be fabricated with a relatively large area to reduce random variations in their bias currents. The load devices should have on the order of at least several times the length and width of a minimum sized device of the technology, such as a reset transistor, and may function even better if their gate areas are at least one hundred times the gate area of a minimum sized transistor. Alternatively, the load devices 158 may be coupled to a first potential, such as ground, and to a column reset line 160, which allows the load devices 158 to act as column reset switches.

The column lines 152 are also coupled to column select switches 162. The column select switches 162 may be of any type design, such as MOS transistors. The column select switches are enabled by a decoder and connected to a common line 164 such that when the appropriate signal is received from the decoder, the column select switch 162 is activated and the signal from that column flows onto the common line 164. The common line 164 is coupled to a buffer amplifier 166, which amplifies the signal.

The use of a single buffer amplifier rather than a multiplicity of column amplifiers reduces fixed pattern striped noise because there are no longer variations due to the offset and gain of each column amplifier. One disadvantage of this design is that the settling time constant of the high capacitance common line being driven only by the small amplifier in the pixel sensor is obviously quite slow. Normally, this would make it difficult to get a high pixel signal rate. However, if the multiplexing of the circuit is performed rapidly, then the voltage on the common line does not settle to an asymptotic value but instead quickly settles to a value determined by charge sharing between the column line and the common line, with a time constant limited by the column select switch rather than by the pixel sensor's amplifier. It is not the same value that would be read out if the circuit were operated at a low multiplexing rate, but it is related by a simple first-order discrete-time function.

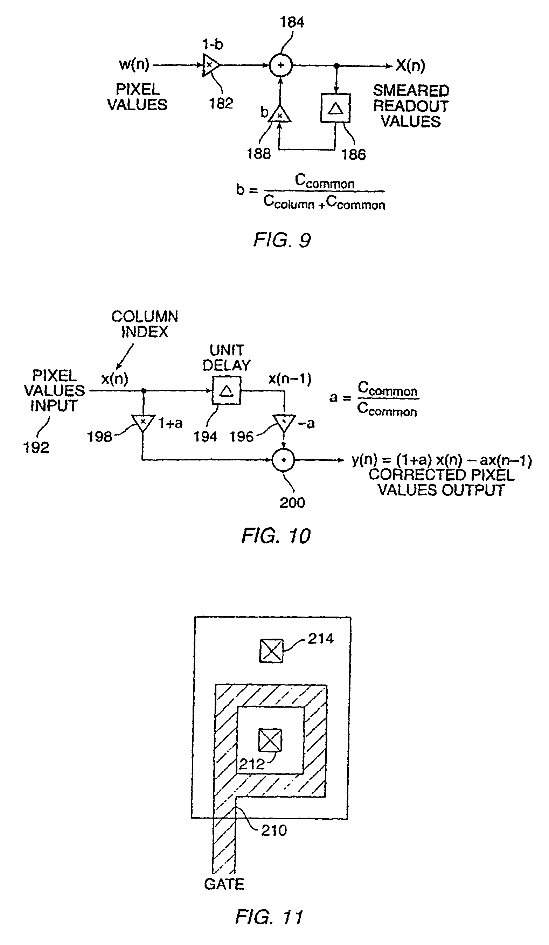

When the column select switch closes, the potentials on the column line and the common line equalize by charge moving as needed from one to the other. The final potential is a linear combination of the two potentials before closing the switch, with weight 1-*b* for the column line potential and *b* for the common line potential, where *b* is the ratio of the common line capacitance to the sum of the common line and column line capacitances. FIG. 9 shows this operation as a signal flow diagram of a first-order recursive discrete-time filter in which the sample delay 186 corresponds to memory of the previous column's signal on the common line, and multipliers 182 and 188 are the weights discussed. If the columns are selected rapidly relative to the time constant associated with the pixel sensor driving the column line, then this filter is a good model of the resulting signals read out through the final amplifier.

The charge-shared column readout arrangement is thus essentially a discrete-time filter which smears the pixel values. Each smeared charge-shared output value *x*(*n*) is the weighted sum of the ideal column signal *w*(*n*) and the previous output *x*(*n*-1), with weight 1-*b* for the ideal column signal and b for the previous output, where *b* is the ratio of the common line capacitance to the sum of the common line and column line capacitances.

Referring again to FIG. 8, a two-tap finite-impulse-response (FIR) filter 172 may then be used to correct for the smearing or blurring of the pixel values. Such a filter is illustrated in FIG. 10. Smeared pixel values input 192 is received from the array amplifier and sent to a unit delay 194. The pixel values input 192 is also sent to a multiplier 198. The output from the unit delay 194 is also sent to a multiplier 196. Multiplier 198 then multiplies *x*(*n*) by 1+*a*, where *a* is the capacitance of the common line divided by the capacitance of the column line. Multiplier 196 then multiplies *x*(*n*-1) by -*a*. Adder 200 adds the outputs of the multipliers 196, 198 together, arriving at a corrected pixel value output (1+*a*)*x*(*n*) - *ax*(*n*-1), which is theoretically exactly equal to the original column signal *w*(*n*) if the coefficient a is chosen correctly.

Even with the addition of the two-tap FIR filter, there are still some minor disadvantages introduced when using the circuit with the load devices used as bias current sources. The load devices are still a potential cause of striped noise. The bias currents are always flowing in all columns during readouts in order to keep the columns charged to the correct voltage so there is a considerable waste of power. The pixel sensor amplifier, acting as a source follower, responds nonlinearly at the time the column is selected and the voltage on the column line changes, which introduces a slight non-linearity into the resulting discrete-time filter.

In order to remedy these concerns, the whole system may be operated dynamically using linear charge sharing as the only mechanism for getting the signal out. For each row, all column lines are discharged to ground using the load device as a column reset switch. The column reset switch is then turned off and the row select line is activated for a predetermined length of time, connecting the amplifiers in the pixel sensors to the column lines, where they work against the dynamics of charging up the capacitance of the column line rather than against a current source load. The voltages on the column lines increase logarithmically, about 60 mV per common log unit of the length of time they are turned on, rather than on an exponential approach to an asymptote.

After a predetermined time, the column reset switches are turned off. The column lines are charged to voltages in a known predetermined relation to the signals at the inputs of the pixel sensor amplifiers, with random variations that depend on the particular amplifiers but not on the column lines, because the column line capacitances are well matched. One column line at a time is then selected to be connected to the common line, sharing the charges between the selected column line and the common line, and thereby creating a very linear discrete-time filtered version of the sequence of column signals across the row, with little or no dependence on the rate or duration of the column select signals. The design and timing of the column decoder that drives the column select switches must be done with care as known in the art to assure that no glitches occur, because glitches may cause unwanted sharing of charge with columns that are not supposed to be selected.

Another potential problem that may be addressed is the effective capacitance of the common line, which may be so high as to cause the charge sharing to severely blur the column signals across the row. Referring to FIG. 8, this may be addressed by coupling a unity-gain buffer amplifier 168 to the common line 164 in a similar fashion as the array amplifier 166. The output from this unity-gain buffer 168, however, is used as a driven shield line 170 around the common line 164, which will reduce the effective capacitance of the common line 164 and reduce blurring. The driven shield 170 may be placed on multiple levels of metal above, below, and to the sides of the common line 164 to greatly reduce the effective capacitance.

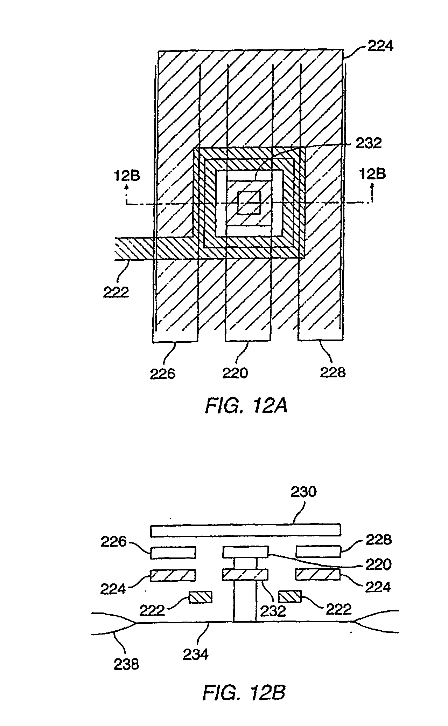

Another optional feature which reduces the effective capacitance of the common line is to design the gate electrode of each column select switch transistor so that it is laid out in an annular fashion around the output terminal to the common line. FIG. 11 is a layout drawing showing a select switch transistor having an annular design. Gate electrode 210 fully surrounds source/drain terminal 212, causing source/drain terminal 212 to have a low capacitance relative to source/drain terminal 214, thus reducing the effective capacitance of the common line to which source/drain terminal 212 is connected.

FIG. 12A is a partial layout drawing of a multiple-level driven shield around the common line. FIG. 12B is a corresponding cross section taken at section line 12B-12B in FIG. 12A. Common line 220 on the Metal-2 layer is coupled to each column select switch annular MOS transistor through Metal-1 pad 232 through openings in the insulating oxide layers. The driven shield preferably includes several surrounding portions: an underlying Metal-1 portion 224 with an opening around pad 232; flanking Metal-2 portions 226 and 228; and an overlying Metal-3 portion 230 (shown only in FIG. 12B). The gate 222 of the annular MOS transistor is also shown, as are field oxide areas 236 and thin oxide area 234 associated with the annular MOS transistor.

It is also preferable to design the circuit in such a way as to have the fixed pattern noise due to random variations of the pixels at least 100 times the variance (10 times the root mean square) of the fixed pattern striped noise so that the random texture of the image will mask any residual striped pattern. Prior art systems with CDS typically have a larger striped than random error.

Referring back to FIG. 8, it may also be helpful to add a capacitor 174 tied to each column line 152. This capacitor may then be referenced to a fixed voltage potential, for example ground. This would further reduce blurring and would be especially helpful when the pixel sensor array has only one row, a configuration known as a linear imaging array.

While embodiments and applications of this invention have been shown and described, it would be apparent to those skilled in the art that many more modifications than mentioned above are possible without departing from the inventive concepts herein.

## Claims

1. A method of reading out voltages from a row of pixel sensors, including the steps of:
- discharging all of the column lines in an array of pixel sensors to ground using column reset switches;
- turning off column reset switches and driving a row-select line to an active level for an appropriate row, activating row-select switches in the row, which connects source followers in each pixel sensor in the row to the column lines;
- waiting a predetermined time for the column lines to be charged and then driving the row-select line back to an inactive level;
- selecting one column line at a time to connect to a common line,
- thereby sharing the charges between the selected column line and said common line; and
- buffering the voltages on said common line.

2. The method of claim 1, further including the step of correcting the blurring that may occur in said voltages.

3. The method of claim 1 or 2, further including the steps of:
- buffering the voltages on the common line using a unity-gain buffer amplifier; and
- using the output of said unity-gain buffer amplifier to drive a shield around said common line to reduce the effective capacitance of the common line.

4. The method of claim 3, wherein said shield is placed on multiple layers of metal around the common line.

5. The method of claim 1 to 4, further including the step of keeping the rms of fixed pattern noise due to random variations of the pixels above 10 times the rms fixed pattern striped noise.

6. The method of claim 1 to 5, wherein column readout is operated with a column switching interval that is short compared to the settling time constant of said column lines.

## Patentansprüche

1. Verfahren zum Auslesen von Spannungen aus einer Zeile Bildpunksensoren mit den Schritten:
- Entladen aller Spaltenleitungen in einer Matrix Bildpunktsensoren nach Masse unter Verwendung von Spalten-Rücksetzschaltern;
- Abschalten der Spalten-Rücksetzschalter und Treiben einer Zeilenanwahlleitung auf einen aktiven Pegel für eine geeignete Zeile, wobei Zeilenanwahlschalter in der Zeile aktiviert werden, wodurch Source-Folger in jedem Bildpunktsensor in der Zeile mit den Spaltenleitungen verbunden werden;
- Abwarten einer vorgegebenen Zeit, bis die Spaltenleitungen geladen sind, und dann Treiben der Zeilenanwahlleitung zurück auf einen inaktiven Pegel;
- Wählen jeweils einer Spaltenleitung zur Verbindung mit einer gemeinsamen Leitung;
- dadurch gemeinsame Nutzung der Ladungen zwischen der gewählten Spaltenleitung und der gemeinsamen Leitung; und
- Puffern der Spannungen auf der gemeinsamen Leitung.

2. Verfahren nach Anspruch 1, das des Weiteren den Schritt der Korrektur von Unschärfen enthält, die in diesen Spannungen auftreten können.

3. Verfahren nach Anspruch 1 oder 2, das des Weiteren folgende Schritte enthält:
- Puffern der Spannungen auf der gemeinsamen Leitung unter Verwendung eines Pufferverstärkers mit Verstärkungsfaktor eins; und
- Verwendung des Ausgang des Pufferverstärkers mit Verstärkungsfaktor eins, um eine Abschirmung um die gemeinsame Leitung zur Verringerung der effektiven Kapazität der gemeinsamen Leitung zu treiben.

4. Verfahren nach Anspruch 3, bei dem die Abschirmung auf mehreren Metallschichten um die gemeinsame Leitung angeordnet wird.

5. Verfahren nach Anspruch 1 bis 4, das des Weiteren den Schritt enthält, in dem der Effektivwert der Festmuster-Störungen aufgrund von Zufallsschwankungen der Bildpunkte über dem 10-Fachen des Effektivwertes der streifenförmigen Festmuster-Störungen gehalten wird.

6. Verfahren nach Anspruch 1 bis 5, bei dem das Spaltenauslesen mit einem Spaltenschaltintervall durchgeführt wird, das im Vergleich zur Einschwingzeitkonstante der Spaltenleitungen kurz ist.

## Revendications

1. Procédé de lecture des tensions d'une rangée de détecteurs à pixels, comprenant les étapes de:
- déchargement de toutes les lignes de colonnes dans une rangée de détecteurs à pixels à la terre en utilisant des commutateurs de réinitialisation de colonnes;
- mise hors circuit des commutateurs de réinitialisation de colonnes et commande d'une ligne de sélection de rangées à un niveau actif pour une rangée appropriée, activation des commutateurs de sélection de rangées dans la rangée, qui connecte les suiveurs de source dans chaque détecteur à pixels dans la rangée ou ligne de colonnes;
- attente d'un période prédéterminée pour le chargement des lignes de colonnes, puis retour de la ligne de sélection de rangées à un niveau inactif;
- sélection d'une ligne de colonnes à un moment donné pour la connexion à une ligne commune,
- partage ainsi des charges entre la ligne de colonnes sélectionnée et ladite ligne commune; et
- tamponnage des tensions sur ladite ligne commune.

2. Procédé selon la revendication 1, comprenant par ailleurs l'étape de correction du manque de netteté qui peut se produire dans lesdites tensions.

3. Procédé selon la revendication 1 ou 2, comprenant par ailleurs les étapes de:
- tamponnage des tensions sur la ligne commune en utilisant un amplificateur de mémoire-tampon à gain unité; et
- utilisation du débit dudit amplificateur de mémoire-tampon à gain unité pour commander un blindage autour de ladite ligne commune afin de réduire la capacité effective de la ligne commune.

4. Procédé selon la revendication 3, dans lequel le blindage est placé sur des couches multiples de métal autour de la ligne commune.

5. Procédé selon la revendication 1 à 4, comprenant par ailleurs l'étape de maintien de la valeur efficace d'un bruit à configuration fixe dû à des variations aléatoires des pixels supérieures à 10 fois le bruit à configuration fixe de valeur efficace.

6. Procédé selon la revendication 1 à 5, dans lequel la lecture de la colonne est effectuée avec un intervalle de commutation de colonne court par rapport à la constante de temps de stabilisation desdites lignes de la colonne.
